**Europäisches Patentamt**

**European Patent Office**

**Office européen des brevets**

(11) Numéro de publication: **0 200 266**

**A1**

## (12) DEMANDE DE BREVET EUROPEEN

(21) Numéro de dépôt: **86200699.6**

(22) Date de dépôt: **23.04.86**

(51) Int. Cl.⁴: **H03K 5/15** , H03K 3/356 , H03K 3/037

(30) Priorité: **26.04.85 FR 8506408**

(43) Date de publication de la demande:
**10.12.86 Bulletin 86/45**

(84) Etats contractants désignés:
**CH DE FR GB IT LI NL**

(71) Demandeur: **Laboratoires d'Electronique et de Physique Appliquée L.E.P.**
**3, Avenue Descartes**
**F-94450 Limeil-Brévannes(FR)**
Demandeur: **N.V. Philips' Gloeilampenfabrieken**
**Groenewoudseweg 1**
**NL-5621 BA Eindhoven(NL)**

(72) Inventeur: **Rocchi, Marc**
**Société Civile S.P.I.D. 209 rue de l'Universié**
**F-75007 Paris(FR)**
Inventeur: **Delhaye, Etienne**
**Société Civile S.P.I.D. 209 rue de l'Universié**
**F-75007 Paris(FR)**

(74) Mandataire: **Landousy, Christian et al**
**Société Civile S.P.I.D. 209, Rue de l'Université**
**F-75007 Paris(FR)**

(54) **Circuit générateur de signaux alternatifs complémentaires.**

(57) Circuit générateur de signaux alternatifs complémentaires pour constituer les signaux d'entrée d'un diviseur de fréquence, caractérisé en ce qu'il est constitué d'un premier circuit inverseur formé d'un étage inverseur et d'un étage suiveur, ce premier circuit inverseur recevant le signal d'entrée alternatif E et fournissant le complémentaire $\overline{E}$ de ce signal d'entrée alternatif, en ce qu'il est constitué en outre de deux branches formée chacune de la succession d'un étage inverseur et d'un étage suiveur, la première branche recevant le signal d'entrée alternatif E et fournissant le signal alternatif de sortie $\overline{H}$ complémentaire, et la seconde branche recevant le complémentaire $\overline{E}$ du signal d'entrée E et fournissant le signal alternatif de sortie H, cette seconde branche étant en outre telle que la source du transistor inverseur est polarisée par le signal alternatif d'entrée E, en ce que les éléments dont il est constitué coopèrent pour que les signaux alternatifs H et $\overline{H}$ présentent des fronts de montée abrupts, et en ce que les signaux H et ainsi générés constituent les signaux d'entrée alternatifs d'un diviseur de fréquence organisé en deux étages, un étage maître et un étage esclave, fournissant deux sorties complémentaires Q et $\overline{Q}$ et fonctionnant entre les très basses fréquences et les hyperfréquences.

Application : diviseurs de fréquence large bande

# CIRCUIT GENERATEUR DE SIGNAUX ALTERNATIFS COMPLEMENTAIRES

L'invention concerne un circuit générateur de signaux alternatifs complémentaires pour constituer les signaux d'entrée d'un diviseur de fréquence par deux.

L'invention concerne également un tel circuit générateur de signaux alternatifs auquel est associé un circuit diviseur de fréquence par deux.

L'invention trouve son application dans la réalisation de circuit diviseur de fréquence par deux très large bande c'est-à-dire typiquement entre 40 MHz et 8 GHz.

Un circuit générateur de signaux hyperfréquences est connu de la publication IEEE Journal of Solid-State Circuits Vol.SC-18(1983) June, p.373 et p.374. Ce circuit est composé de deux transistors à effet de champ dont l'un reçoit le signal d'entrée sur sa grille et fournit un premier signal hyperfréquence sur son drain, et dont l'autre reçoit le signal d'entrée sur sa source, sa grille étant polarisée par un signal prélevé au point commun entre une résistance et une diode placées entre la tension d'alimentation continue et la masse, et fournit un second signal hyperfréquences complémentaire du premier sur son drain.

Mais ce circuit générateur d'horloges complémentaires est strictement applicable au circuit diviseur de fréquence par deux présenté dans la même publication.

En effet ce circuit générateur d'horloge présente des transitions lentes, c'est-à-dire des fronts de montée non abrupts. Ceci peut être négligeable dans le circuit diviseur de fréquence par deux présenté dans la publication citée. Mais pour le circuit envisagé dans la présente application à la bande de fréquences 40 MHz-8 GHz ce générateur de signaux doit être absolument écarté. En effet aux basses fréquences, lorsque le front de montée de l'horloge n'est pas suffissamment abrupt, il se crée une indétermination entre le niveau haut et le niveau bas de l'un des étages du diviseur, entraînant une perte totale de l'information. D'autre part, aux très hautes fréquences, la lenteur des transitions du générateur d'horloge limite la fréquence supérieure de fonctionnement du diviseur.

Il est d'autre part connu de la demande de brevet européen 0 098 203 un diviseur de fréquence par deux opérant en hyperfréquences. Mais ce diviseur comprend trois étages. son fonctionnement se fait donc en trois temps de propagation (3 tpd).

De plus, ce circuit connu a été réalisé en logique interfacée BFL,'à l'aide de transistors à effet de champ en arséniure de gallium, à désertion de charges. Les propriétés physico-chimiques de l'arséniure de gallium permettent en effet la réalisation de circuits intégrés fonctionnant à des fréquences très élevées, et les transistors à effet de champ à désertion de charges sont d'une réalisation relativement aisée.

Mais ces transistors à effet de champ, à désertion de charges en arséniure de gallium présentent en contrepartie un certain nombre de défauts.

Tout d'abord, les circuits qui utilisent ces transistors montrent une consommation assez élevée.

Ensuite, ces transistors présentent un phénomène d'hystérésis qui entraîne qu'il est précisément très difficile d'obtenir la complémentarité des signaux d'entrée indispensable au bon fonctionnement du circuit connu.

Ainsi, dans le but de réaliser des circuits intégrés toujours plus performants et à densité d'intégration toujours plus grande, il est recherché de diminuer de plus en plus la consommation des circuits sans pour autant diminuer la vitesse ou la fréquence de fonctionnement.

C'est pourquoi, les transistors à effet de champ à enrichissement, dont la technologie est maintenant satisfaisante, sont à ce jour préférés du fait qu'ils sont dépourvus des défauts inhérents aux transistors à désertion de charges, et que leur consommation est environ dix fois moindre.

Mais les circuits conçus pour être réalisés dans une technologie incluant des transistors à désertion de charges (normalement passant en l'absence de signal grille-source) ne peuvent être transposés purement et simplement dans une technologie incluant des transistors à enrichissement - (normalement bloqués en l'absence de signal grille-source). En effet ces circuits fonctionnent dans de bonnes conditions à l'aide des transistors à désertion de charges du fait que les portes présentent des excursions logiques importantes - (supérieures à 1V), le report de la tension d'un étage au suivant étant réalisé par l'intermédiaire d'étages translateurs de niveaux à diodes imposant l'utilisation d'une tension d'alimentation continue supplémentaire.

Au contraire, les portes réalisées à l'aide de transistors à effet de champ à enrichissement présentent une excursion logique faible qui impose l'utilisation de signaux d'entrée présentant des fronts de montée abrupts sous peine d'indétermination.

C'est pourquoi la présente invention propose un nouveau circuit générateur de signaux alternatifs complémentaires qui permet de s'affranchir de ces difficultés.

Selon l'invention ce circuit est remarquable en ce qu'il est constitué d'un premier circuit inverseur formé d'un étage inverseur et d'un étage suiveur, ce premier circuit inverseur recevant le signal d'entrée alternatif E et fournissant le complémentaire $\overline{E}$ de ce signal d'entrée alternatif, en ce qu'il est constitué en outre de deux branches formée chacune de la succession d'un étage inverseur et d'un étage suiveur, la première branche recevant le signal d'entrée alternatif E et fournissant le signal alternatif de sortie $\overline{H}$ complémentaire, et la seconde branche recevant le complémentaire $\overline{E}$ du signal d'entrée E et fournissant le signal alternatif de sortie H, cette seconde branche étant en outre telle que la source du transistor inverseur est polarisée par le signal alternatif d'entrée E, en ce que les éléments dont il est constitué coopèrent pour que les signaux alternatifs H et $\overline{H}$ présentent des fronts de montée abrupts, et en ce que les signaux H et $\overline{H}$ ainsi générés constituent les signaux d'entrée alternatifs d'un diviseur de fréquence organisé en deux étages, un étage maître et un étage esclave, fournissant deux sorties complémentaires Q et $\overline{Q}$ et fonctionnant entre les très basses fréquences et les hyperfréquences.

Ce circuit peut être en outre remarquable en ce que dans le circuit diviseur de fréquence, chaque étage maître et chaque étage esclave est formé de deux portes de multiplexage et en ce que chaque porte de multiplexage est constituée de deux portes NON-OU et d'une porte OU-CABLE et reçoit d'une part les signaux alternatifs H et $\overline{H}$ et d'autre part le signal rebouclé en croix de la sortie de l'autre porte de multiplexage du même étage, et le signal de sortie de l'une des portes de multiplexage de l'autre étage.

Ce circuit peut être encore remarquable en ce qu'il est réalisé à l'aide de transistors à effet de champ du type dit à enrichissement normalement pincés en l'absence de signal grille-source, en ce qu'il comporte des moyens pour diminuer le temps de propagation dans les portes NON-OU, et en ce que, chaque porte NON-OU étant formée de deux transistors en parallèle dont les sources couplées sont reliées à la masse, dont les drains couplés sont portés à la tension d'alimentation continue $V_{DD}$ à travers une résistance de charge, et dont les grilles reçoivent les entrées de la porte, les moyens pour diminuer le temps de propagation dans cette porte NON-OU sont constitués par le fait que la sortie de la porte, qui est disponible sur les drains couplés, est reportée sur l'entrée d'un étage dit tampon composé d'un transistor dont le drain est porté directement à l'alimentation continue $V_{DD}$, et dont la source est portée à la masse à travers une résistance dont la valeur est choisie pour que la capacité d'entrée de l'étage tampon soit faible et qu'ainsi la résistance de charge de la porte NON-OU soit également faible, ce qui produit la diminution recherchée du temps de propagation dans cette porte.

Ce circuit peut être de plus remarquable en ce que chaque OU-CABLE est formé par la réunion des surces des transistors des étages tampons des deux portes NON-OU d'une porte de multiplexage et en ce que la résistance de polarisation de ces transistors d'étage tampon est mise en commun pour n'en faire qu'une, la sortie du OU-CABLE étant alors au point commun entre ces sources et cette résistance, en sorte que le temps de transit dans le diviseur est celui de la somme des temps de transit dans deux transistor et que $\delta$ étant le temps de propagation dans une porte NON-OU, la fréquence maximale $f_M$ de fonctionnement de la partie diviseur de fréquence est donnée par la relation :

$$f_M = \frac{1}{2\delta}$$

Le circuit selon l'invention fournit donc un double avantage. D'une part, au moyen de la structure OU-CABLE utilisée dans le diviseur, le temps de transit dans ce dernier ne dépasse pas le temps de transit dans deux transistors, ce qui à l'évidence améliore les performances de cette partie du circuit par rapport à l'art antérieur où le temps de transit était celui de trois transistors du fait que la fonction OU était réalisée par un transistor supplémentaire.

Cet avantage est rendu possible du fait de la structure particulière du générateur d'horloge qui fournit des signaux présentant des temps de montée très courts, permettant d'attaquer un tel diviseur.

D'autre part l'ensemble de ces circuits permet un fonctionnement sur une bande de fréquence très large 40 MHz-8 GHz avec une consommation de l'ordre de 40 mW c'est-à-dire extrêmement réduite par rapport à l'art antérieur et l'utilisation d'une seule tension d'alimentation ce qui simplifie considérablement le circuit.

L'invention sera mieux comprise à l'aide de la description suivante illustrée par les figures annexées dont :

-la figure 1 qui représente le schéma logique du circuit selon l'invention ;

-la figure 2a qui représente une porte complexe du circuit selon l'invention, cette porte étant réalisée à l'aide de transistors à effet de champ à enrichissement ;

-la figure 2b qui représente le circuit selon l'invention réalisé à l'aide d'une telle porte complexe ;

-la figure 3 qui représente le diagramme temporel du circuit en fonctionnement ;

la figure 4 qui représente le circuit générateur de signaux d'entrée complémentaires ;

la figure 5 qui représente les courbes de transfert de ce dernier circuit.

Dans le but de rendre plus évident l'avantage procuré par le circuit générateur de signaux alternatifs complémentaires selon l'invention, il est décrit ici en premier lieu le circuit diviseur de fréquences par deux dont les entrées sont générées par celui-ci.

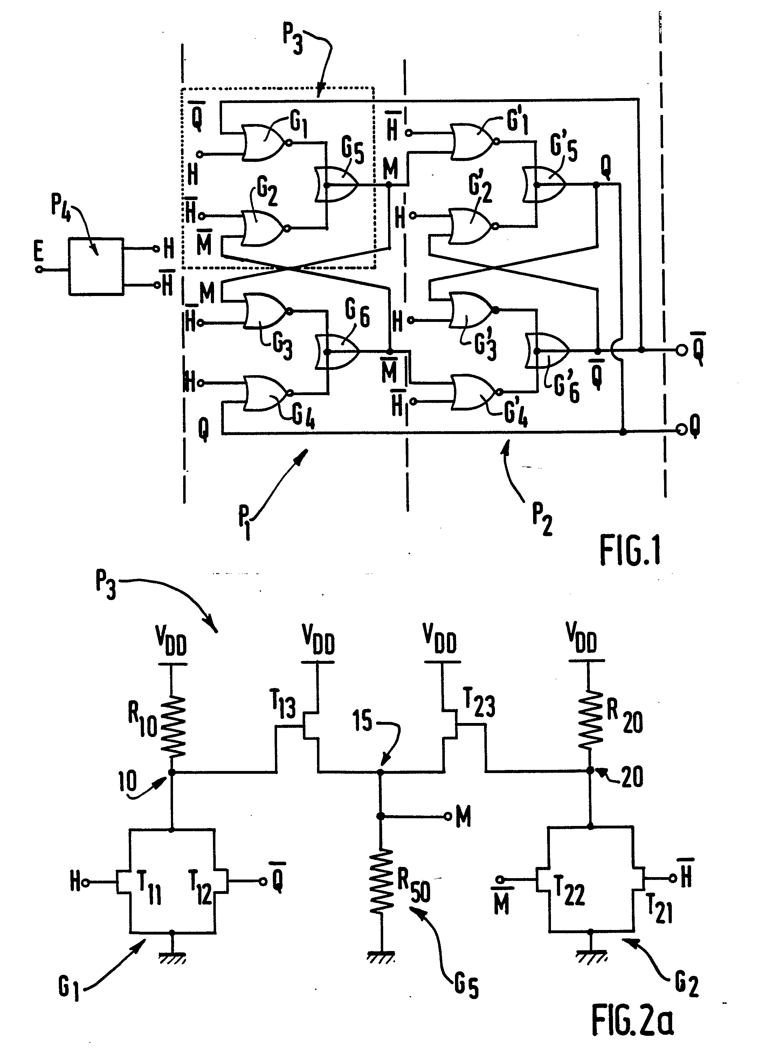

Tel que représenté sur la figure 1, le circuit diviseur est donc constitué de deux étages, un étage maître $P_1$ et un étage esclave $P_2$. Chacun de ces étages est formé de deux portes complexes dites de multiplexage NON-OU, OU.

Ainsi le maître est formé d'une première porte de multiplexage comportant deux portes NON-OU notées $G_1$ et $G_2$, et une porte OU notée $G_5$, et d'une seconde porte de multiplexage comportant deux portes NON-OU notées $G_3$ et $G_4$ et une porte OU notée $G_6$.

L'esclave est formé d'une première porte de multiplexage comportant deux portes NON-OU notées $G'_1$ et $G'_2$ et une porte OU notée $G'_5$, et d'une seconde porte de multiplexage comportant deux portes NON-OU notée $G'_3$ et $G'_4$ et une porte OU notée $G'_6$.

Les portes $G_1$ et $G_4$ du maître reçoivent chacune le signal d'entrée alternatif H. La porte $G_1$ reçoit en outre la sortie complémentaire $\bar{Q}$ issue de la porte $G'_6$ de l'esclave, tandis que la porte $G_4$ reçoit en outre la sortie Q issue de la porte $G'_5$ de l'esclave.

Les portes $G_2$ et $G_3$ du maître reçoivent chacune le signal d'entrée complémentaire $\bar{H}$. La porte $G_2$ reçoit en outre le complémentaire $\bar{M}$ du signal intermédiaire, issu de la porte $G_6$ du maître, tandis que la porte $G_3$ reçoit en outre le signal intermédiaire M issu de la porte $G_5$ du maître.

Les portes OU $G_5$ et $G_6$ du maître réalisent en fait uniquement le cablage des sorties des portes $G_1$ et $G_2$ d'une part, et $G_3$ et $G_4$ d'autre part. Ces portes $G_5$ et $G_6$ dites "OU-CABLE" ne comportent donc aucun temps de propagation.

Les portes $G'_1$ et $G'_4$ de l'esclave reçoivent chacune le complémentaire $\bar{H}$ du signal d'entrée alternatif. La porte $G'_1$ reçoit en outre le signal intermédiaire M issu de la porte $G_5$ du maître, tandis que la porte $G'_4$ reçoit le complémentaire $\bar{M}$ du signal intermédiaire, issu de la porte $G_6$ du maître.

Les portes $G'_2$ et $G'_3$ de l'esclave reçoivent chacune le signal d'entrée alternatif H. La porte $G'_2$ reçoit en outre le signal complémentaire $\bar{Q}$ issu de la porte $G'_6$ de l'esclave, tandis que la porte $G'_3$ reçoit en outre le signal de sortie Q issu de la porte $G'_5$ de l'esclave.

Les portes $G'_5$ et $G'_6$ de l'esclave sont formées respectivement par le cablage des sorties des portes $G'_1$ et $G'_2$ d'une part, et $G'_3$ et $G'_4$ d'autre part, en sorte qu'elles forment des OU-CABLES tout à fait semblables aux portes $G_5$ et $G_6$ du maître.

Dans un exemple de réalisation avantageuse de la présente invention, ce circuit est formé de transistors à effet de champ, par exemple en arséniure de gallium (GaAs), du type dit à enrichissement, c'est-à-dire normalement bloqués à tension grille-source nulle (Normally-OFF). Ces transistors présentent en effet à ce jour les meilleures performances du fait de leur très grande vitesse de fonctionnement et de leur très faible consommation.

Les caractéristiques de ces transistors sont en effet les suivantes :

Pour une grille surbaissée, la tension de pincement

$V_T \simeq 0$

La largeur de grille Lg $\simeq$ 0,7 $\mu$m

$I_{DS} \sim$ 75 A/ $\mu$m à 0,7 V (courant drain-source à saturation).

$G_m \simeq$ 200 mS/mm (gain du transistor en courant)

avec 1 Siemens (S) = 1 Ampère/Volt

Cependant, dans le but d'améliorer encore la vitesse de commutation du circuit en fonctionnement par rapport à l'art antérieur, la porte de multiplexage incluant deux portes NON-OU telles que $G_1$ et $G_2$ et un OU-CABLE tel que $G_5$ est prévue selon le schéma de la figure 2a.

Telle que représentée sur la figure 2a, cette porte de multiplexage $P_3$ comprend donc une première porte NON-OU, par exemple $G_1$, formée de deux transistors $T_{11}$ et $T_{12}$ montés en parallèle et chargés sur une résistance $R_{10}$, et une seconde porte NON-OU, par exemple $G_2$, formée de deux transistors $T_{21}$ et $T_{22}$ montés en parallèle et chargés sur une résistance $R_{20}$. Le signal de sortie issu de ces portes est disponible respectivement aux noeuds 10 et 20 et est reporté sur les grilles des transistors $T_{13}$ et $T_{23}$, dont les drains sont portés directement à l'alimentation continue $V_{DD}$ et dont les sources sont couplées et portées à la masse par l'intermédiaire d'une résistance $R_{50}$.

Le noeud 15 de couplage des sources des transistors $T_{13}$ et $T_{23}$ constitue la fonction OU-CABLE de la porte $G_5$ par exemple. Les transistors $T_{13}$ d'une part, et $T_{23}$ d'autre part, associés à la résistance $R_{50}$, constituent chacun un étage dit "tampon".

Dans le circuit selon l'invention, la valeur de la résistance $R_{50}$ est choisie pour que la capacité d'entrée du transistor de l'étage tampon soit faible, et que la compatibilité des niveaux soit néanmoins conservée. Ceci permet d'utiliser des résistances de charge des portes NON-OU, telles que $R_{10}$ et $R_{20}$, de faible valeur ; et par conséquent ceci permet d'augmenter la vitesse de fonctionnement de la porte NON-OU.

Une porte NON-OU associée à un étage tampon, telle que décrite précédemment présente donc comme avantages :

-une faible sensibilité à la sortance,

-un très faible temps de commutation permettant d'atteindre des fréquences de l'ordre de 6 GHz à l'entrée du circuit diviseur de fréquence selon l'invention.

-une très faible consommation propre aux transistors à enrichissement.

Une porte de multiplexage $P_3$ telle que représentée figure 2a fournit en sortie la fonction complexe (par exemple pour les portes $G_1$, $G_2$ et $G_5$) :

$$M = \overline{\overline{M} + \overline{H}} + \overline{H + \overline{Q}} = M \cdot H + Q \cdot \overline{H}$$

Cette fonction est réalisée en un seul tpd (tpd = time propagation delay en anglo-saxon).

Cette structure est très différente de celle de l'art antérieur (brevet EP 0098203) dans laquelle les étages tampons sont des étages translateurs de niveau à diodes et utilisent 1 tpd supplémentaire, ce qui fait que le temps de transit pour le diviseur se monte à 3 tpd au lieu de 2 tpd selon la présente invention.

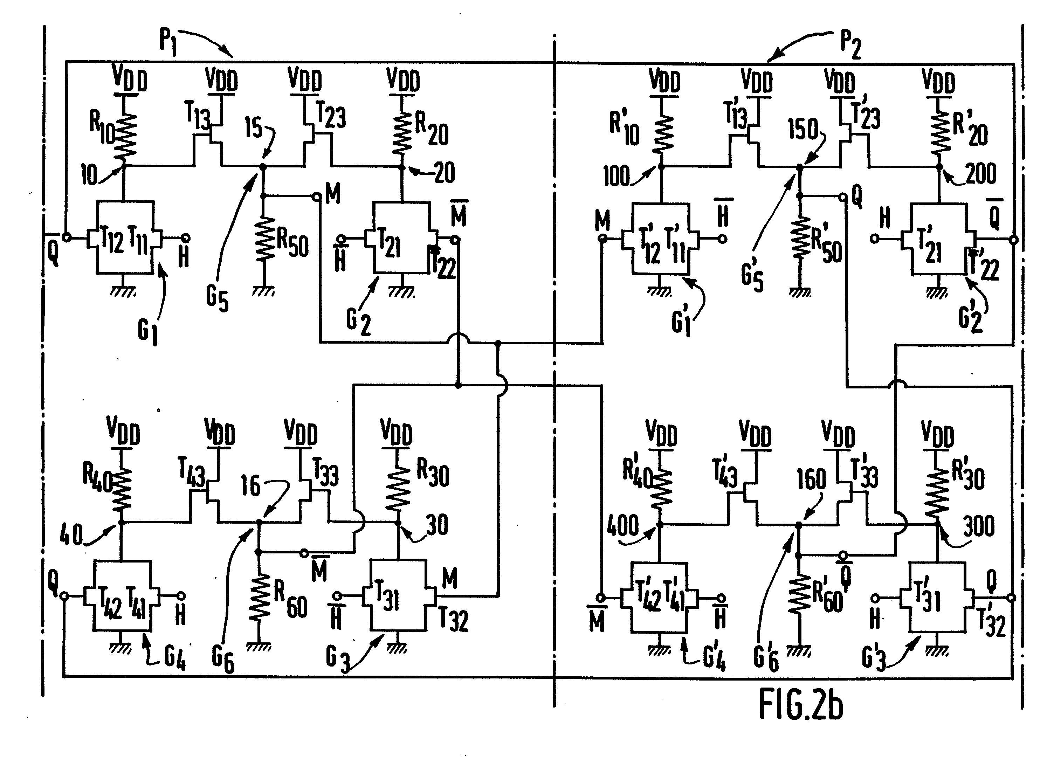

La figure 2b représente le circuit complet diviseur de fréquence par deux selon l'invention, réalisé à l'aide de quatre portes de multiplexage.

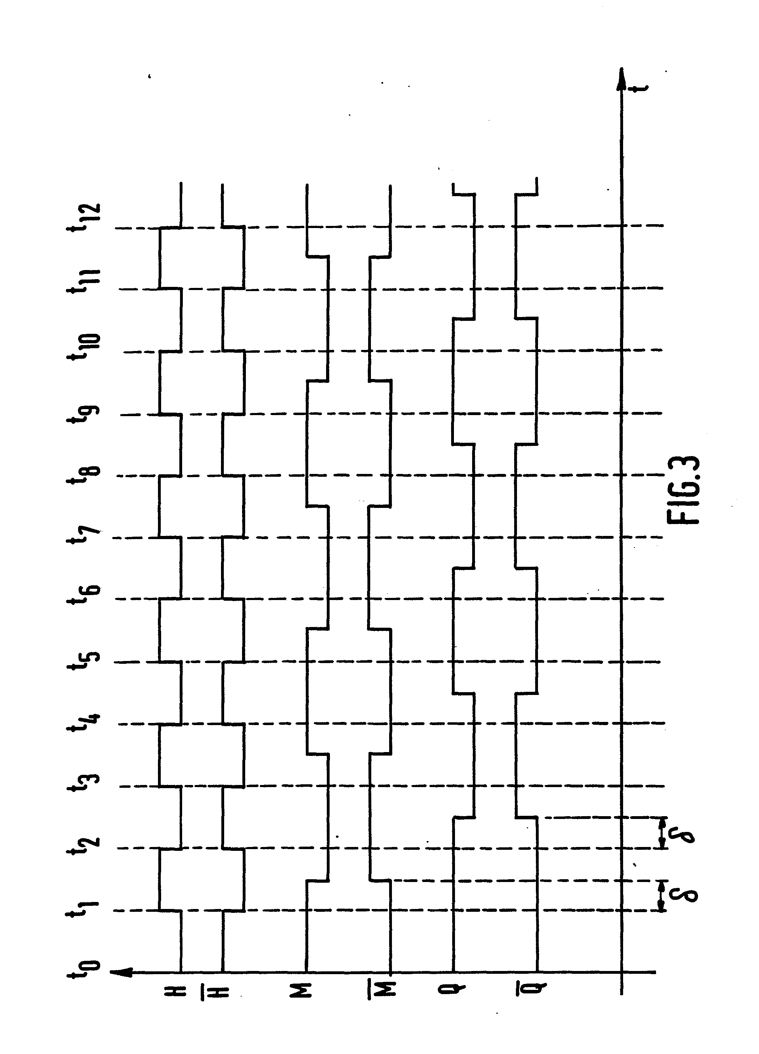

La figure 3 montre le diagramme temporel de fonctionnement de ce circuit. En s'appuyant sur la figure 1, et en supposant que l'état initial du système à l'instant $t_0$ est celui que est donné dans le tableau I :

| TABLEAU I | | | |
|---|---|---|---|
| Instant $t_0$ | H = 0 | M = 0 | Q = 1 |
| | $\overline{H}$ = 1 | $\overline{M}$ = 1 | $\overline{Q}$ = 0 |

alors, lors de la première transition, à l'instant $t_1$, l'esclave se ferme -il y a mémorisation-et le signal intermédiaire M passe au niveau haut exactement en même temps que son complémentaire $\overline{M}$ passe au niveau bas. Cet état du signal intermédiaire M et de son complémentaire $\overline{M}$ est atteint au bout d'un temps noté $\delta$ après l'instant $t_1$.

Lorsque ensuite, à l'instant $t_2$, le signal d'entrée H revient à zéro, et que son complémentaire $\overline{H}$ passe à 1, le maître se ferme et passe donc en mode de mémorisation. Les signaux de sortie Q et son complémentaire $\overline{Q}$ changent de niveau au bout d'un temps $\delta$ après l'instant $t_2$.

La fréquence maximale théorique $f_M$ de fonctionnement du diviseur de fréquence par deux selon l'invention est donc :

$$f_M = \frac{1}{2\delta}$$

Mais le but est de réaliser un circuit diviseur que soit capable de fonctionner sur une très large bande de fréquences, c'est-à-dire non seulement en hyperfréquences, comme il a été dit précédemment, mais aussi en basses fréquences - (de l'ordre de 40 MHz). C'est pourquoi, il doit être adjoint au diviseur de fréquence proprement dit un circuit générateur de signaux d'entrée complémentaires capable de générer de tels signaux présentant des transitions abruptes.

En effet, lors d'une transition du signal d'entrée H, on a vu que, chaque étage, maître, ou esclave, passe alternativement d'une phase de mémorisation à une phase d'acquisition et inversement.

Analysons alors plus précisément le fonctionnement du OU-CABLE représenté par exemple figure 2a, les transistors étant du type à enrichissement.

Avec une tension d'alimentation continue $V_{DD}$ = 2V, une entrée inactive sur l'un des transistors - ($T_{23}$ par exemple) du OU-CABLE se traduit par un niveau logique bas d'environ 0,4 V. En supposant l'entrée de l'autre transistor ($T_{13}$) haute, le niveau logique est d'environ 1,5 V. Le niveau de sortie au noeud 15 est alors de l'ordre de 0,8 V.

Lors de la transition, l'entrée de $T_{13}$ passe au niveau bas, alors que l'entrée de $T_{23}$ monte. Cependant, le résultat doit être une conservation du niveau haut en sortie sur le noeud 15.

Or le transistor $T_{23}$ doit compenser une tension grille-source de l'ordre de 0,6 V avant de devenir suffisamment passant pour imposer le niveau haut au noeud 15. Ce point 15 réagira donc dans un premier temps à $T_{13}$ et son niveau commencera par chuter.

Ce problème peut être négligeable en hyperfréquences du fait du très faible temps de propagation (tpd) de chaque porte.

Il n'en est pas de même à plus basse fréquence. Si les signaux d'entrée présentent des transitions lentes, une perte d'information peut advenir.

Il suffit cependant, pour assurer un bon fonctionnement d'une porte de multiplexage telle que représentée figure 2a, que le transitions des signaux d'entrée basse-fréquences soient abruptes.

Or le circuit connu de l'art antérieur - (Publication IEEE Vol. SC-18 (1983) p.374) n'avait pour but que de fournir la bonne complémentarité des signaux de sortie et non pas des fronts de montée abrupts en basse fréquence.

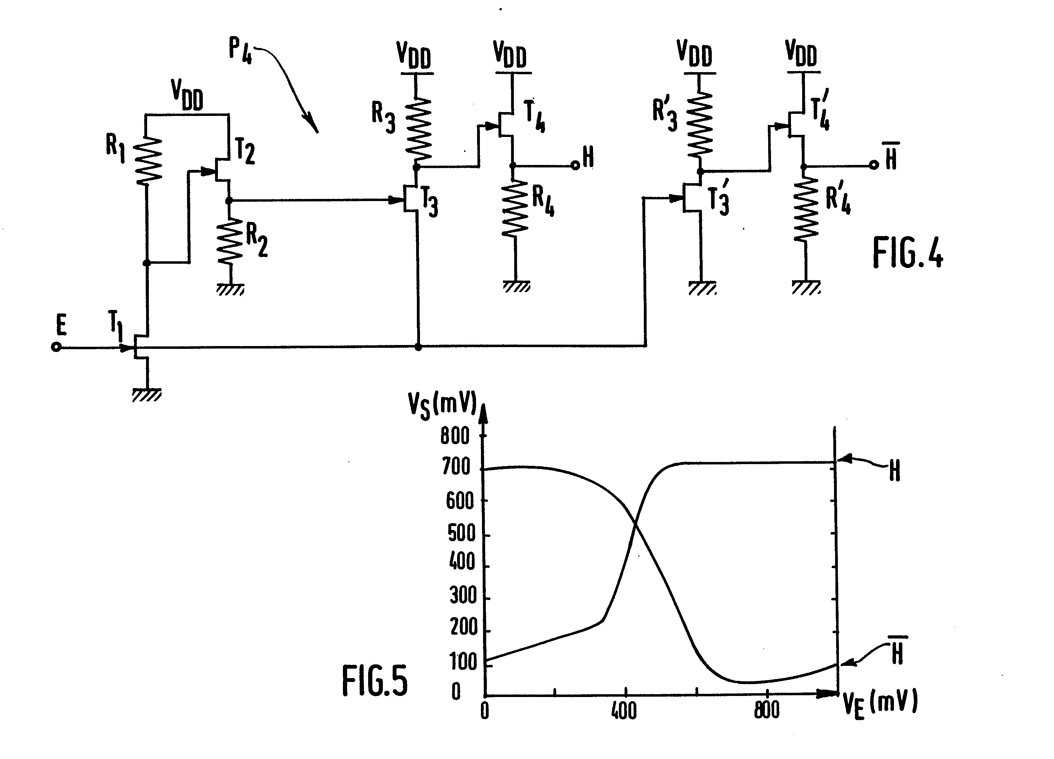

En revanche, ce résultat peut être obtenu à l'aide du circuit $P_4$ selon l'invention générateur de signaux d'entrée complémentaires, capable en outre de redresser les fronts de transition des signaux d'entrée basse-fréquences (figure 4 et figure 5).

Cette solution avantageuse réside dans un circuit double, dont chacune des parties est formée de la succession de deux étages, un étage inverseur et un étage suiveur, circuit que génère les deux signaux d'entrée H et $\overline{H}$ du diviseur, en opposition de phase, à partir d'un signal alternatif d'entrée E.

Ce circuit $P_4$ est représenté figure 4. Les étages inverseurs sont formés du transistor $T_3$ et de la résistance $R_3$ d'une part, et du transistor $T'_3$ et de la résistance $R'_3$ d'autre part. Les étages suiveurs sont formés du transistor $T_4$ et de la résistance $R_4$ d'une part, et du transistor $T'_4$ et de la résistance $R'_4$ d'autre part.

Comme il serait très difficile de maintenir à un niveau fixe, avec une polarisation ordinaire, la tension grille du transistor suiveur $T_3$ du fait qu'il s'agit d'un transistor à effet de champ et que le courant de grille n'est pas nul, alors le circuit de polarisation de grille de ce transistor doit être spécialement étudié. Selon l'invention, la grille du transistor $T_3$ est polarisée avec l'inverse du signal d'entrée E, le signal E lui-même étant appliqué sur la source du transistor $T_3$.

Le circuit $P_4$ générateur des signaux d'entrée complémentaires H et $\overline{H}$, tel que représenté figure 4, réalisé avec la même technologie que le circuit diviseur et alimenté par les mêmes tensions continues, présente un gain G, tel que G = 5 qui permet d'obtenir des transitions abruptes pour les signaux H et $\overline{H}$, même aux basses fréquences, et donc un fonctionnement parfait du diviseur sur une très large bande de fréquences.

La figure 5 montre les courbes de transfert de ce circuit $P_4$ générateur de signaux, dans les conditions de réalisation exposées dans le tableau II. L'excursion est de l'ordre de 500 mV en sortie ($V_S$) pour 100 mV en entrée ($V_E$), dans la zone de gain maximal.

En tenant compte du fait que les quatre portes de multiplexage sont identiques, le tableau II donne les valeurs de la largeur de grille des transistors, et les valeurs des résistances des circuits tel que représentés figure 2a d'une part et figure 4 d'autre part.

| TABLEAU II | | | |
|---|---|---|---|
| Transistors | Largeur de grille | Résistances | Valeur |
| $T_{11}$, $T_{12}$ | 20 μm | $R_{10}$, $R_{20}$ | 2 KΩ |
| $T_{22}$, $T_{21}$ | 20 μm | $R_{50}$ | 0,8 KΩ |
| $T_{13}$, $T_{23}$ | 40 μm | | |
| $T_1$ | 100 μm | R1, $R_4$ | 0,3 KΩ |
| $T_2$ | 60 μm | $R_2$ | 0,35 KΩ |
| | | $R_3$ | 1,2 KΩ |
| $T_3$, $T_4$ | 45 μm | | |
| | | $R'_3$ | 1,5 KΩ |
| $T'_3$, $T'_4$ | 45 μm | | |
| | | $R'_4$ | 0,5 KΩ |

Ainsi réalisés ces circuits permettent d'obtenir un fonctionnement du diviseur dans un domaine de fréquences f telles que :

40 MHz ≤ f ≤ 8 GHz

avec une consommation

P ≈ 40 mW

On notera encore qu'une seule tension d'alimentation continue est utilisée :

$V_{DD} ≈ 1V$

Des variantes peuvent être apportées à la réalisation de ces circuits sans pour autant sortir du cadre la présente invention tel que défini par les revendications ci-après annexées. ·

**Revendications**

1. Circuit générateur de signaux alternatifs complémentaires pour constituer les signaux d'entrée d'un diviseur de fréquence, caractérisé en ce qu'il est constitué d'un premier circuit inverseur formé d'un étage inverseur et d'un étage suiveur, ce premier circuit inverseur recevant le signal d'entrée alternatif E et fournissant le complémentaire $\bar{E}$ de ce signal d'entrée alternatif, en ce qu'il est constitué en outre de deux branches formée chacune de la succession d'un étage inverseur et d'un étage suiveur, la première branche recevant le signal d'entrée alternatif E et fournissant le signal alternatif de sortie $\bar{H}$ complémentaire, et la seconde branche recevant le complémentaire $\bar{E}$ du signal d'entrée E et fournissant le signal alternatif de sortie H, cette seconde branche étant en outre telle que la source du transistor inverseur est polarisée par le signal alternatif d'entrée E, en ce que les éléments dont il est constitué coopèrent pour que les signaux alternatifs H et $\bar{H}$ présentent des fronts de montée abrupts, et en ce que les signaux H et $\bar{H}$ ainsi générés constituent les signaux d'entrée alternatifs d'un diviseur de fréquence organisé en deux étages, un étage maître et un étage esclave, fournissant deux sorties complémentaires Q et $\overline{Q}$ et fonctionnant entre les très basses fréquences et les hyperfréquences.

2. Circuit selon la revendication 1, caractérisé en ce que dans le circuit diviseur de fréquence, chaque étage maître et chaque étage esclave est formé de deux portes de multiplexage et en ce que chaque porte de multiplexage est constituée de deux portes NON-OU et d'une porte OU-CABLE et reçoit d'une part les signaux alternatifs H et $\overline{H}$ et d'autre part le signal rebouclé en croix de la sortie de l'autre porte de multiplexage du même étage, et le signal de sortie de l'une des portes de multiplexage de l'autre étage.

3. Circuit selon la revendication 2, caractérisé en ce qu'il est réalisé à l'aide de transistors à effet de champ du type dit à enrichissement normalement pincés en l'absence de signal grille-source, et en ce qu'il comporte des moyens pour diminuer le temps de propagation dans les portes NON-OU.

4. Circuit selon la revendication 3, caractérisé en ce que, chaque porte NON-OU étant formée de deux transistors en parallèle dont les sources couplées sont reliées à la masse, dont les drains couplés sont portés à la tension d'alimentation continue $V_{DD}$ à travers une résistance de charge, et dont les grilles reçoivent les entrées de la porte, les moyens pour diminuer le temps de propagation dans cette porte NON-OU sont constitués par le fait que la sortie de la porte, qui est disponible sur les drains couplés, est reportée sur l'entrée d'un étage dit tampon composé d'un transistor dont le drain est porté directement à l'alimentation continue $V_{DD}$, et dont la source est portée à la masse à travers une résistance dont la valeur est choisie pour que la capacité d'entrée de l'étage tampon soit faible et qu'ainsi la résistance de charge de la porte NON-OU soit également faible, ce qui produit la diminution recherchée du temps de propagation dans cette porte.

5. Circuit selon la revendication 4, caractérisé en ce que chaque OU-CABLE est formé par la réunion des surces des transistors des étages tampons des deux portes NON-OU d'une porte de multiplexage et en ce que la résistance de polarisation de ces transistors d'étage tampon est mise en commun pour n'en faire qu'une, la sortie du OU-CABLE étant alors au point commun entre ces sources et cette résistance, en sorte que le temps de transit dans le diviseur est celui de la somme des temps de transit dans deux transistor et que $\delta$ étant le temps de propagation dans une porte NON-OU, la fréquence maximale $f_M$ de fonctionnement de la partie diviseur de fréquence est donnée par la relation :

$$f_M = \frac{1}{2\delta}$$

6. Circuit selon la revendication 5 caractérisé en ce que les transistors sont en arséniure de gallium - (GaAs) en sorte que la fréquence de fonctionnement f est comprise dans le domaine :

40 MHz ≤ f ≤ 8 GHz

et la consommation est de l'ordre de P ≃ 40 mW.

FIG.1

FIG.2a

FIG.2b

FIG.3

3–Ⅳ–PHF 85–529

0 200 266

FIG.4

FIG.5

0 200 266

| Office européen des brevets | RAPPORT DE RECHERCHE EUROPEENNE | Numéro de la demande<br>EP 86 20 0699 |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | FR-A-2 423 818 (LABORATOIRE CENTRAL DE TELECOMMUNICATIONS) * Figures 1,2; page 2, ligne 1 - page 3, ligne 5 * | 1-6 | H 03 K 5/15<br>H 03 K 3/356<br>H 03 K 3/037 |
| | --- | | |
| Y | EP-A-0 098 203 (THOMSON-CSF) * Figures 4-7; page 6, ligne 9 - page 7, ligne 19 * | 1-6 | |
| | --- | | |
| A | IEEE JOURNAL OF SOLID-STATE CIRCUITS, vol. SC-18, no. 3, juin 1983, pages 369-376, New York, US; M. ROCCHI et al.: "GaAs digital dynamic IC's for applications up to 10 GHz" * Page 373, colonne de droite, ligne 18 - page 374, ligne 2; figures 12,13 * | 1 | |
| | --- | | DOMAINES TECHNIQUES RECHERCHES (Int. Cl.4) |
| A | EP-A-0 075 915 (TOSHIBA) * Figures 4-11, 15-18; page 8, ligne 14 - page 13, ligne 30; page 15, ligne 26 - page 18, ligne 14 * | 1 | H 03 K 3<br>H 03 K 19<br>H 03 K 5 |
| | ---     -/- | | |

Le présent rapport de recherche a été établi pour toutes les revendications

| Lieu de la recherche<br>LA HAYE | Date d'achèvement de la recherche<br>09-07-1986 | Examinateur<br>DAVIS A.G.W. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

| | **DOCUMENTS CONSIDERES COMME PERTINENTS** | | Page 2 |
|---|---|---|---|
| **Catégorie** | Citation du document avec indication, en cas de besoin, des parties pertinentes | Revendication concernée | CLASSEMENT DE LA DEMANDE (Int. Cl.4) |
| A | IEE PROCEEDINGS-I, vol. 127, no. 5, partie 1, octobre 1980, pages 287-295, Stevenage, GB; "G. NUZILLAT et al.: "Low pinch-off voltage f.e.t. logic (l.p.f.l.): l.s.i. oriented logic approach using quasinormally off GaAs m.e.s.f.e.t.s." <br> * Figures 3,10a,11a; page 293, colonne de gauche, ligne 14 - colonne de droite, ligne 3 * <br><br> --- | 1-6 | |
| A | ELECTRONICS, vol. 53, no. 22, octobre 1980, pages 76-78, New York, US; K. DREYFACK: "Gallium arsenide to yield 5-GHz divider" * Page 78, figure * <br><br> ----- | 2-6 | |
| | | | **DOMAINES TECHNIQUES RECHERCHES (Int. Cl.4)** |

Le présent rapport de recherche a été établi pour toutes les revendications

| Lieu de la recherche | Date d'achèvement de la recherche | Examinateur |
|---|---|---|
| LA HAYE | 09-07-1986 | DAVIS A.G.W. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82